# EUROPEAN PATENT APPLICATION

(11) **EP 4 693 261 A1**
(43) Date of publication of application: **11.02.2026**
(21) Application number: 24855235.8
(22) Date of filing: 01.03.2024
(51) Int. Cl.: G09F 9/30

(54) **ELECTRONIC DEVICE**

(30) Priority: 24.08.2023 CN 202322297539 U
(71) Applicant: Huawei Technologies Co., Ltd., Shenzhen, Guangdong 518129 (CN)
(72) Inventor: LI, Yunchao, Shenzhen, Guangdong 518129 (CN); HUANG, Tai, Shenzhen, Guangdong 518129 (CN); ZHANG, Lei, Shenzhen, Guangdong 518129 (CN); ZHAO, Fuliang, Shenzhen, Guangdong 518129 (CN); GUO, Zhibin, Shenzhen, Guangdong 518129 (CN); GUO, Anmin, Shenzhen, Guangdong 518129 (CN); MA, Liang, Shenzhen, Guangdong 518129 (CN)
(74) Representative: MERH-IP Matias Erny Reichl Hoffmann Patentanwälte PartG mbB
(86) International application number: PCT/CN2024/079514
(87) International publication number: WO 2025/039504

(57) **Abstract**

This application provides an electronic device. The electronic device includes an optical film, a support member, a backplane, a frame, and at least one avoidance structure. The backplane includes a folded edge portion, the support member includes a first portion, and the optical film includes at least one mounting ear. Along a first direction, the first portion is disposed between the folded edge portion and the frame. Each avoidance structure corresponds to one mounting ear, at least a part of each avoidance structure is disposed on the folded edge portion, and each avoidance structure defines an avoidance space used to accommodate at least a part of the corresponding mounting ear. With the electronic device provided in this application, a width of the frame can be reduced, to improve delicacy of an appearance of the electronic device.

## Description

This application claims priority to Chinese Patent Application No. 202322297539.5, filed with the China National Intellectual Property Administration on August 24, 2023 and entitled "ELECTRONIC DEVICE", which is incorporated herein by reference in its entirety.

### TECHNICAL FIELD

Embodiments of this application relate to the field of terminal technologies, and in particular, to an electronic device.

### BACKGROUND

Currently, for an electronic device having a display, like a television (for example, a smart screen), an advertising screen, a monitor, a tablet computer, or an e-reader, delicacy of an appearance affects user experience. For example, the electronic device is a television. A ground facing-side frame of the television includes a middle frame and the ground facing-side frame. The ground facing-side frame is disposed on a ground-facing side of a display panel. Along a thickness direction of the display panel, a display side of the display panel laps with an inner side of the ground facing-side frame. However, because a width of the ground facing-side frame is wide along a direction perpendicular to the thickness direction of the display panel, an appearance of the television is not delicate enough. Therefore, how to improve delicacy of the appearance of the television becomes an urgent problem to be resolved.

### SUMMARY

Embodiments of this application provide an electronic device, to reduce a width of a frame, and improve delicacy of an appearance of the electronic device.

This application provides an electronic device, including an optical film, a support member, a backplane, a frame, and at least one avoidance structure. The backplane includes a folded edge portion, the support member includes a first portion, and the optical film includes at least one mounting ear. Along a first direction, the first portion is disposed between the folded edge portion and the frame. Each avoidance structure corresponds to one mounting ear, at least a part of each avoidance structure is disposed on the folded edge portion, and each avoidance structure defines an avoidance space used to accommodate at least a part of the corresponding mounting ear.

In the electronic device provided in this embodiment of this application, at least a part that is of the avoidance structure, that is located on the folded edge portion, and that defines the avoidance space enables the mounting ear to be decoupled from at least the folded edge portion. In this way, a spacing between the optical film and the frame along the first direction can be reduced, and a width of the frame in the first direction can be reduced, to improve delicacy of an appearance of the electronic device.

In a possible implementation, one part of each avoidance structure is disposed on the folded edge portion, and the other part is disposed on the first portion; each avoidance structure includes a first substructure and a second substructure, the first substructure is disposed on the folded edge portion and defines a first space, the second substructure is disposed on the first portion and defines a groove space, the first space and the groove space jointly define the avoidance space, and the groove space is used to accommodate a part that is of the mounting ear and that passes through the first space; and along the first direction, an expansion gap exists between each mounting ear and a groove bottom of the corresponding groove space.

In the electronic device provided in this embodiment of this application, the first space and the groove space fit each other, so that the folded edge portion and a part of the first portion are decoupled from the expansion gap of the mounting ear. In this way, the width of the frame in the first direction can be further reduced, thereby further improving delicacy of the appearance of the electronic device.

In a possible implementation, the groove space includes the groove bottom and a plurality of groove side walls; along the first direction, the plurality of groove side walls are disposed on a same side of the groove bottom; and along a circumferential direction of the groove bottom, the plurality of groove side walls are sequentially connected and define an annular structure having a notch. Using the groove space of such a structure can reduce difficulty in disposing the groove space on the first portion. In addition, processing difficulty and costs of the first portion may be further reduced.

In a possible implementation, one part of each avoidance structure is disposed on the folded edge portion, the other part is disposed on the first portion, and along the first direction, an expansion gap exists between each mounting ear and the frame; and each avoidance structure includes a first substructure and a third substructure, the first substructure is disposed on the folded edge portion and defines a first space, the third substructure is disposed on the first portion and defines a second space, the first space and the second space jointly define the avoidance space, and the second space is used to accommodate a part that is of the mounting ear and that passes through the second space.

In the electronic device provided in this embodiment of this application, one part of the avoidance structure is disposed on the folded edge portion, and the other part is disposed on the first portion, so that an expansion gap exists between the frame and the mounting ear. Therefore, both the folded edge portion and the first portion are decoupled from the expansion gap. In this way, a spacing between the frame and the optical film in the first direction can be further reduced, and the width of the frame in the first direction can be further reduced.

In a possible implementation, the first substructure includes a through notch, and an inner wall of the through notch defines the first space.

In the electronic device provided in this embodiment of this application, the first space that accommodates a part of the mounting ear is defined through the through notch. In this way, not only the folded edge portion can avoid the mounting ear, but also difficulty in disposing the first substructure on the folded edge portion can be reduced.

In a possible implementation, the third substructure includes a through hole, and an inner wall of the through hole defines the second space.

In the electronic device provided in this embodiment of this application, the second space that accommodates a part of the mounting ear is defined through the through hole. In this way, not only the first portion can be decoupled from the expansion gap of the mounting ear, but also strength of the support member can be ensured.

In a possible implementation, each avoidance structure is disposed on the folded edge portion, and along the first direction, an expansion gap exists between each mounting ear and the first portion.

In the electronic device provided in this embodiment of this application, each avoidance structure is disposed on the folded edge portion. In this way, the expansion gap exists between the mounting ear and the first portion, and the folded edge portion is decoupled from the expansion gap of the mounting ear, so that the folded edge portion is decoupled from the mounting ear, to reduce the width of the frame in the first direction.

In a possible implementation, each avoidance structure includes an avoidance notch, and an inner wall of the avoidance notch defines the avoidance space; or each avoidance structure includes an avoidance hole, and an inner wall of the avoidance hole limits the avoidance space. In this way, at least a part of the mounting ear can be accommodated when the optical film is expanded, to reduce the width of the frame in the first direction, and improve delicacy of the appearance of the electronic device.

In a possible implementation, the backplane further includes a first main body portion, and the folded edge portion is disposed on an edge of the first main body portion and is located on a same side of the first main body portion as the optical film; and the first main body portion includes a first portion body and a second portion body, and an included angle between the first portion body and the second portion body is a corner angle.

In the electronic device provided in this embodiment of this application, the included angle between the first portion body and the second portion body of the first main body portion is a corner angle. In this way, while an effective lapping width between a diffuser plate and the backplane is ensured, a spacing between the frame and the folded edge portion can be reduced, and the width of the frame can be further reduced on the basis that the width of the frame is reduced by using the avoidance structure.

In a possible implementation, along a second direction, the first portion body includes a first surface and a second surface that are oppositely disposed, the second portion body includes a third surface and a fourth surface that are oppositely disposed, and the first direction is perpendicular to the second direction; the first surface intersects with the third surface, and the second surface intersects with the fourth surface; and an included angle between the first surface and the third surface is a first included angle, an included angle between the second surface and the fourth surface is a second included angle, and at least one of the first included angle and the second included angle is a corner angle.

In the electronic device provided in this embodiment of this application, at least one of the first included angle and the second included angle is set to a corner angle. In this way, while an effective lapping width of the diffuser plate relative to the backplane is ensured, the width of the frame in the first direction can be reduced.

In a possible implementation, the support member further includes a second portion, and along the first direction, the folded edge portion is disposed between the first portion and the second portion; the second portion includes a first notch and a second notch, the second notch and the first notch are arranged side by side and spaced apart along a third direction, and the first direction, the second direction, and the third direction are perpendicular to each other; the second notch is used to accommodate at least a part of a convex lug of a diffuser plate; and each mounting ear corresponds to one first notch, and each mounting ear is disposed inside the avoidance space through the corresponding first notch.

In the electronic device provided in this embodiment of this application, the second notch used to accommodate the convex lug is disposed on the support member. In this way, not only a lapping width between the diffuser plate and the first main body portion in the first direction can be ensured, but also the width of the frame in the first direction can be further reduced.

In a possible implementation, the electronic device further includes a plurality of support structures; along the first direction, the plurality of support structures are disposed between the frame and the first portion, and two opposite ends of each support structure are respectively in contact with the frame and the first portion; and along a third direction, the plurality of support structures are arranged side by side and spaced apart, a gap between two adjacent support structures is used for passing through by one chip on film that electrically connects a display panel and a drive board, and a gap exists between the chip on film and the adjacent support structures.

In the electronic device provided in this embodiment of this application, the support structure is disposed between the frame and the first portion. In this way, when a size of a chip on film space in the first direction is set to an extreme size, the frame and/or the first portion can be prevented from squeezing the chip on film. This not only can further reduce the width of the frame, but also can ensure that the chip on film is normally bent and/or moved. The chip on film space is a gap jointly defined by the frame and the first portion in the first direction. In addition, the frame and the first portion jointly define a plurality of chip on film spaces, and each chip on film space corresponds to one chip on film.

In a possible implementation, each support structure includes a support rib, and the support rib is disposed between the frame and the first portion and is of an integral structure with one of the frame and the first portion.

In the electronic device provided in this embodiment of this application, the support rib that is of the integral structure with one of the frame and the first portion is used. In this way, not only the frame and/or the first portion can be prevented from squeezing the chip on film, but also difficulty in disposing the support rib can be reduced. In addition, production efficiency of the electronic device can be further improved.

In a possible implementation, the electronic device further includes a display panel and a non-transparent bonding member, and the support member further includes a third portion; and along a second direction, the first portion and the display panel are respectively disposed on two opposite sides of the third portion, a part of the display panel is disposed between the frame and the third portion, and the bonding member is disposed between the third portion and the display panel and is bonded to each of the third portion and the display panel.

In the electronic device provided in this embodiment of this application, the third portion is bonded to the display panel through the non-transparent bonding member. In this way, not only a lapping width between the frame and the display panel in the first direction can be reduced, to further reduce the width of the frame in the first direction, but also screen flickering and/or light transmission can be further avoided when the lapping width between the frame and the display panel is reduced. The screen flickering means that a state in which a part of the display panel is located between the third portion and the frame changes to a state in which a part of the frame is located between the display panel and the third portion. Light transmission means that light inside the electronic device is emitted through a gap between the display panel and the third portion.

In a possible implementation, along the first direction, a lapping width between the display panel and the frame is greater than or equal to 1 mm, and a lapping width between the display panel and the frame is less than or equal to 3 mm.

In the electronic device provided in this embodiment of this application, the lapping width between the display panel and the frame in the first direction is greater than or equal to 1 mm and less than or equal to 3 mm. In this way, the lapping width between the frame and the display panel is very small, to further reduce the width of the frame in the first direction.

In a possible implementation, the bonding member includes a double-sided foam tape.

In the electronic device provided in this embodiment of this application, the third portion is bonded to the display panel through the double-sided foam tape. In this way, not only the width of the frame in the first direction can be further reduced, but also the display panel can be further separated from the support member, to repair or replace the display panel.

In a possible implementation, the electronic device further includes a plurality of eccentric structures, the plurality of eccentric structures are arranged side by side and spaced apart along a third direction, and along the first direction, the plurality of eccentric structures are disposed between the frame and the first portion, and each eccentric structure is in contact with each of the frame and the first portion.

In the electronic device provided in this embodiment of this application, an eccentric structure that enables the frame to rotate around a direction parallel to the third direction by a specific angle is disposed between the frame and the first portion, so that the frame rotates toward the display panel. In this way, a gap between the display panel and the frame in the second direction can be reduced, and delicacy of the appearance of the electronic device can be further improved. In other words, the eccentric structure is used, so that an included angle can exist between a top end surface of the frame in the second direction and a display surface of the display panel.

In a possible implementation, each eccentric structure includes an eccentric rib, and the eccentric rib is disposed between the frame and the first portion along the first direction and is of an integral structure with one of the frame and the first portion.

In the electronic device provided in this embodiment of this application, the eccentric rib that is of the integral structure with one of the frame and the first portion is disposed. In this way, not only the frame can rotate relative to the display panel, to reduce a size of a gap between the frame and the display panel, but also difficulty in disposing the eccentric structure can be further reduced. In addition, production efficiency of the electronic device can be further improved.

In a possible implementation, the frame further includes a fastening hole, the fastening hole is used for passing through by a fastener that fastens the frame and the folded edge portion, the fastening hole is an eccentric hole, and an axis of the fastening hole is parallel to the first direction.

In the electronic device provided in this embodiment of this application, the fastening hole is disposed as an eccentric hole, so that the axis of the fastening hole is parallel to the first direction. In this way, it can be ensured that an axis of the fastener is parallel to the first direction when the fastener is inserted for fastening, and it can be ensured that the fastener can be connected to the folded edge portion. Therefore, the fastening hole is disposed as an eccentric hole. In this way, difficulty in connecting the frame and the folded edge portion by the fastener can be reduced.

In a possible implementation, the frame includes a second main body portion and a support plate portion; one end of the support plate portion is detachably connected to the second main body portion, and the other end of the support plate portion is configured to lap with a surface that is of a display panel and that faces away from the optical film along the second direction; and along the first direction, the first portion is disposed between the second main body portion and the folded edge portion.

In the electronic device provided in this embodiment of this application, the second main body portion and the frame including the second main body portion are detachably connected, and the support plate portion laps with the display panel. In this way, not only flatness of the support plate portion can be better controlled, to further improve delicacy of the appearance of the electronic device, but also a thickness of the support plate portion can be further reduced, to implement a thin design. In addition, support plate portions made of different materials may alternatively be used, which brings different appearance experience to a user.

In a possible implementation, the support plate portion is any one of the following: a stainless steel plate portion, a plastic plate portion, an aluminum plate portion, a carbon fiber plate portion, a vinyl chloride plate portion, a PCM plate portion, or a polycarbonate plate portion. When the stainless steel plate portion serves as the support plate portion, a thickness of the support plate portion in the second direction can be reduced as much as possible while a risk of deformation of the support plate portion is reduced, to implement a thin design. In addition, the support plate portions made of different materials fit the display panel, so that aesthetics of the electronic device can be improved.

In a possible implementation, the second main body portion is bonded to one end of the support plate portion; and along the second direction, one end that is of the second main body portion and that faces the support plate portion includes an anti-overflow adhesive stopper and a positioning groove, a top end surface of the anti-overflow adhesive stopper is in contact with a bottom end surface of the support plate portion and defines an accommodation cavity with the bottom end surface of the support plate portion, and a part of the support plate portion is disposed inside the positioning groove. In this way, the second main body portion and the support plate portion can be bonded, to improve assembly efficiency of the second main body portion and the support plate portion. In addition, glue for bonding the anti-overflow adhesive stopper and the support plate portion may be located in the accommodation cavity, to block the glue and/or prevent overflow of the glue. In addition, a part of the support plate portion is disposed in the positioning groove. In this way, a relative position between the support plate portion and the second main body portion can be ensured.

In a possible implementation, the frame is a ground facing-side frame. In this way, the width of the ground facing-side frame can be reduced.

In a possible implementation, the electronic device is any one of the following: a television, an advertising screen, or a monitor.

### BRIEF DESCRIPTION OF DRAWINGS

FIG. 1 is a first partial sectional view of an electronic device in a related technology;
FIG. 2 is a second partial sectional view of the electronic device in FIG. 1;
FIG. 3 is a diagram of a structure of a first electronic device according to an embodiment of this application;
FIG. 4 is a first partial sectional view of the electronic device in the embodiment shown in FIG. 3;
FIG. 5 is a second partial sectional view of the electronic device in the embodiment shown in FIG. 3;
FIG. 6 is a diagram of structure of a support member in FIG. 4 and FIG. 5;
FIG. 7 is a sectional view in a V-V direction in FIG. 6;
FIG. 8 is a diagram of a structure of an optical film according to an embodiment of this application;
FIG. 9 is a diagram of a structure of a diffuser plate according to an embodiment of this application;
FIG. 10 is a diagram of a first partial three-dimensional structure of the electronic device in the embodiment shown in FIG. 3;
FIG. 11 is a third partial sectional view of the electronic device in the embodiment shown in FIG. 3;
FIG. 12 is a diagram of a second partial three-dimensional structure of the electronic device in the embodiment shown in FIG. 3;
FIG. 13 is a fourth partial sectional view of the electronic device in the embodiment shown in FIG. 3;
FIG. 14 is a partial sectional view of a frame of the electronic device in the embodiment shown in FIG. 3;
FIG. 15 is a partial sectional view of a second electronic device according to an embodiment of this application;
FIG. 16 is a partial sectional view of a third electronic device according to an embodiment of this application; and
FIG. 17 is a partial sectional view of a fourth electronic device according to an embodiment of this application.

Reference numerals:
110: display panel;
120: frame; 121: second main body portion; 1211: anti-overflow adhesive stopper; 1212: positioning groove; 122: support plate portion; 1221: first support plate section; 1222: second support plate section; 123: fastening hole;
130: support member; 131: first portion; 132: second portion; 133: third portion; 134: first notch; 135: second notch; 136: via hole;
140: chip on film;
150: optical film; 151: first body; 152: mounting ear;
160: diffuser plate; 161: second body; 162: convex lug;
170: backplane; 171: first main body portion; 1711: first portion body; 1712: second portion body; 172: folded edge portion; 1721: threaded hole; 173: mounting plate portion;
180: bonding member;
190: reflector plate; 200: middle frame;
10: avoidance structure; 20: support structure; 30: eccentric structure; 40: groove space;
101: first substructure; 102: third substructure; and
A1: first surface; A2: second surface; A3: third surface; A4: fourth surface; R1: first included angle; R2: second included angle.

### DESCRIPTION OF EMBODIMENTS

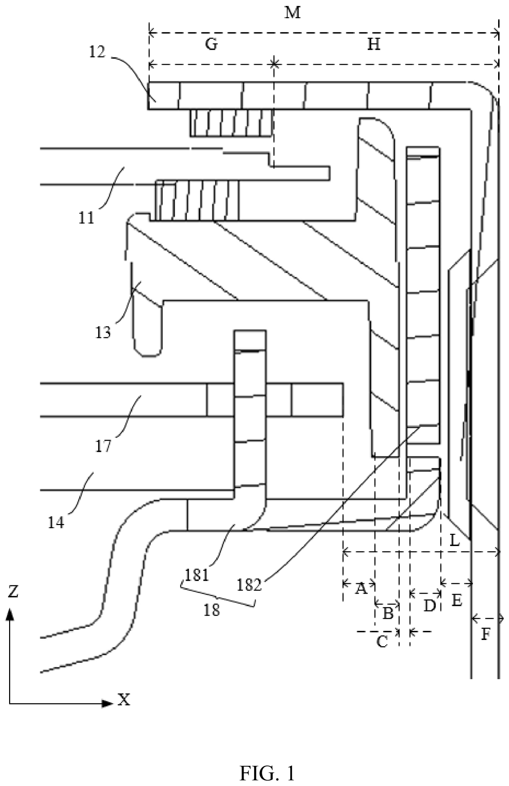

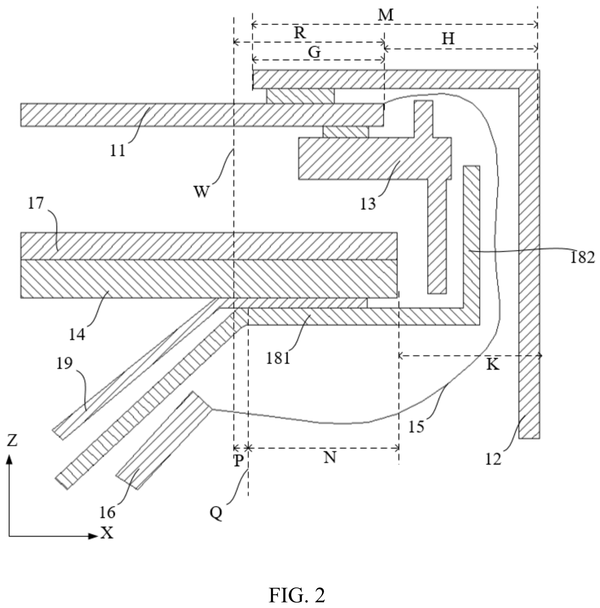

FIG. 1 is a first partial sectional view of an electronic device in a related technology. FIG. 2 is a second partial sectional view of the electronic device in FIG. 1. With reference to FIG. 1 and FIG. 2, the electronic device includes a display panel 11, a ground facing-side frame 12, a plastic frame 13, a diffuser plate 14, a chip on film 15, a drive board 16, an optical film 17, a backplane 18, and a reflector plate 19. The backplane 18 includes a main body portion 181 and a folded edge portion 182. Along a first direction (a Z direction in FIG. 1), the folded edge portion 182, the diffuser plate 14, the plastic frame 13, the display panel 11, and the optical film 17 are disposed on a same side of the main body portion 181. The diffuser plate 14 is disposed between the optical film 17 and the main body portion 181 and laps with the main body portion 181. The plastic frame 13 and the folded edge portion 182 are connected and are configured to support the display panel 11. A chip on film space for accommodating the chip on film 15 is defined between the plastic frame 13 and the ground facing-side frame 12. The chip on film 15 is electrically connected to the display panel and the drive board 16 through the chip on film space. A part of the display panel 11 is located between the ground facing-side frame 12 and the plastic frame 13, and the ground facing-side frame 12 laps with the display panel 11.

However, a width of the ground facing-side frame 12 in a second direction (for example, an X direction in FIG. 1) is wide, which reduces delicacy of an appearance of the electronic device. In addition, a thickness of a part that is of the ground facing-side frame 12 and that laps with the display panel 11 in the first direction (for example, a Z direction in FIG. 1) is thick, which also reduces delicacy of the appearance of the electronic device. Therefore, how to improve delicacy of the electronic device becomes an urgent problem to be resolved.

In view of this, an embodiment of this application provides an electronic device, to reduce a width of a frame 120, thereby improving delicacy of an appearance of the electronic device, and further improving user experience. In addition, a thickness of a part that is of the frame 120 and that laps with a display panel 110 may be further reduced, thereby improving delicacy of the appearance of the electronic device.

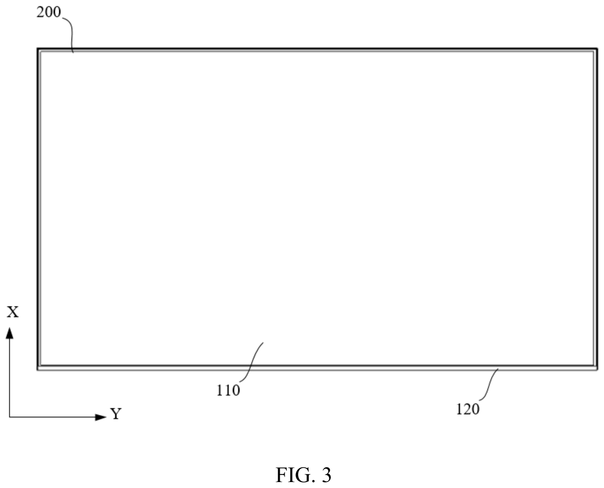

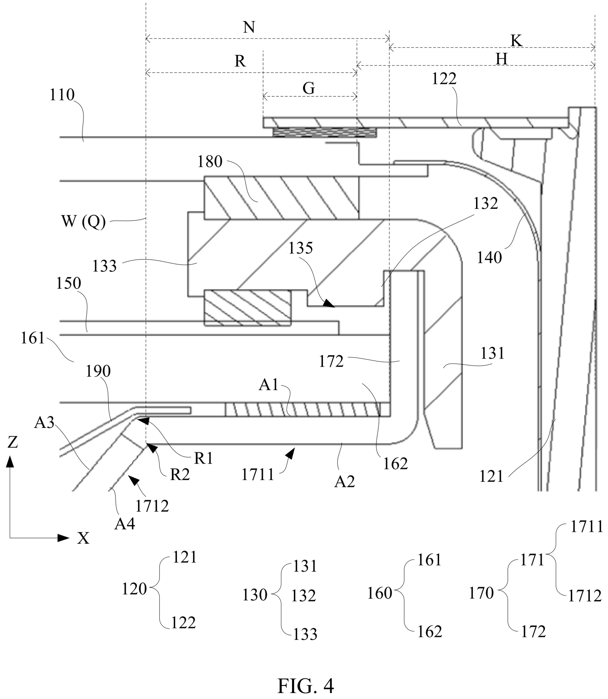

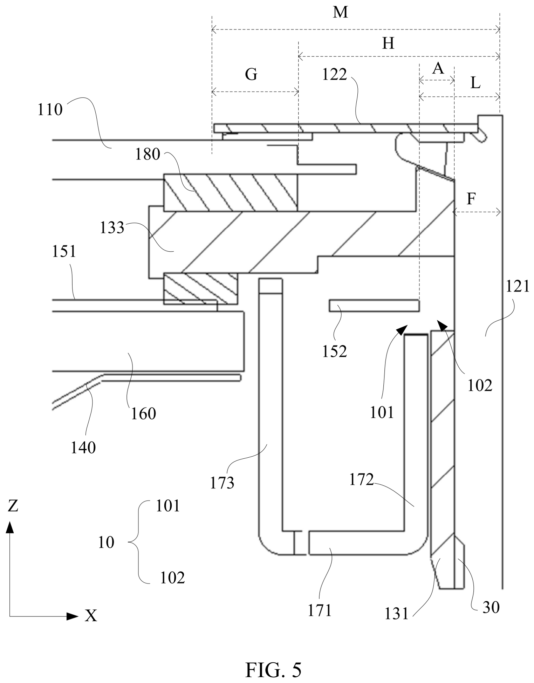

FIG. 3 is a diagram of a structure of a first electronic device according to an embodiment of this application. FIG. 4 is a first partial sectional view of the electronic device in the embodiment shown in FIG. 3. FIG. 5 is a second partial sectional view of the electronic device in the embodiment shown in FIG. 3. With reference to FIG. 3 to FIG. 5, the electronic device provided in this embodiment of this application includes a display panel 110, a frame 120, a support member 130, a chip on film 140, an optical film 150, a diffuser plate 160, a backplane 170, a reflector plate 190, and a middle frame 200. Two ends of the middle frame 200 are respectively close to two opposite ends of the frame 120, and the middle frame 200 and the frame 120 jointly define a frame structure surrounding the display panel 110. The display panel 110, the optical film 150, the diffuser plate 160, and the reflector plate 190 are disposed on a same side of the backplane 170 and are sequentially stacked along a second direction (for example, a Z direction in FIG. 4 or FIG. 5). A first portion 131 of the support member 130 is connected to the backplane 170, the first portion 131 of the support member 130 and the frame 120 define a chip on film space for passing through by the chip on film 140, and a third portion 133 of the support member 130 is configured to support the display panel 110.

The electronic device provided in this embodiment of this application may include but is not limited to a device having a display, like a television (for example, a smart screen), an advertising screen, a monitor, a tablet computer, an e-reader, or a netbook. For example, in this embodiment of this application, an example in which the electronic device is a television is used for detailed description.

The chip on film 140 (chip on flex, or, chip on film, COF for short) provided in this embodiment of this application is configured to electrically connect the display panel 110 and the drive board.

The backplane 170 provided in this embodiment of this application may have functions such as supporting the electronic device and providing mechanical protection for an electronic component in the electronic device. A material of the backplane 170 may be a material that meets a mechanical strength requirement and can provide support. For example, the material of the backplane 170 may be a metal material like stainless steel, aluminum alloy, zinc alloy, or titanium alloy. Alternatively, the backplane 170 may be made of a non-metal material like resin. In addition, with reference to FIG. 4 and FIG. 5, the backplane 170 in this embodiment of this application includes a first main body portion 171, a folded edge portion 172, and a mounting plate portion 173; the mounting plate portion 173 and the folded edge portion 172 are disposed on a same side of the first main body portion 171; the folded edge portion 172 is disposed on an edge of the first main body portion 171; the folded edge portion 172 is configured to connect the support member 130 and the frame 120; and the mounting plate portion 173 is configured to be inserted into a mounting hole of the optical film 150.

The support member 130 provided in this embodiment of this application is configured to support the display panel 110, and may be further configured to press the optical film and/or the diffuser plate 160. When the support member 130 is made of plastic, the support member 130 may also be referred to as a plastic frame. Certainly, the support member 130 may also be made of a metal material. In this embodiment of this application, an example in which the support member 130 is a plastic frame is used for description.

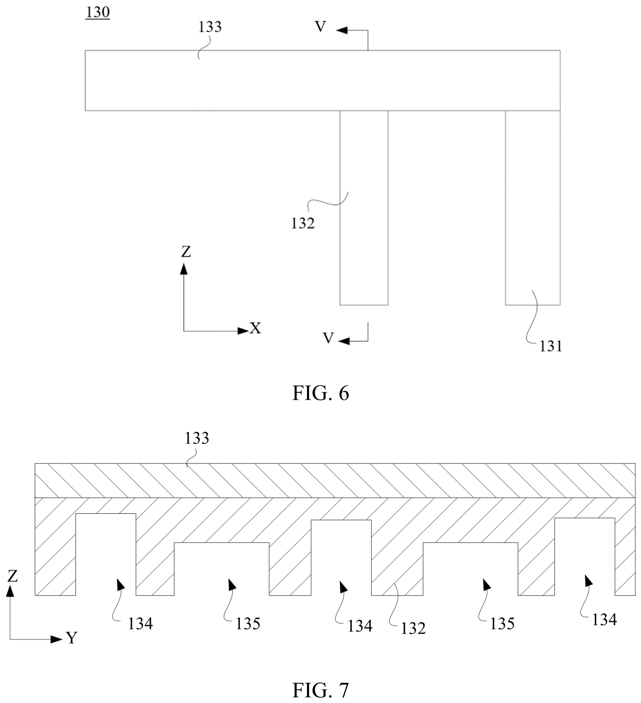

FIG. 6 is a diagram of a structure of the support member in FIG. 4 and FIG. 5. FIG. 7 is a sectional view in a V-V direction in FIG. 6. In addition, with reference to FIG. 4 and FIG. 5 and with reference to FIG. 6 and FIG. 7, the support member 130 in this embodiment of this application includes the first portion 131, a second portion 132, and the third portion 133. Along a first direction (for example, an X direction in FIG. 5 or FIG. 6), the first portion 131 and the second portion 132 are arranged side by side and spaced apart, the first portion 131 and the third portion 133132 are disposed on a same side of the third portion 133, a gap between the first portion 131 and the second portion 132 is used to accommodate the folded edge portion 172 of the backplane 170, the second portion 132 includes a first notch 134 for passing through by a mounting ear 152 of the optical film 150, and the third portion 133 is configured to support the display panel 110. Certainly, in some embodiments, the second portion 132 may alternatively be removed. In other words, the support member 130 may alternatively include the first portion 131 and the third portion 133. Alternatively, in some embodiments, the third portion 132 may be removed.

The display panel 110 provided in this embodiment of this application may include but is not limited to a liquid crystal display (liquid crystal display, LCD) panel, a self-luminous display panel, and the like. When the display panel 110 is a self-luminous display panel, the display panel 110 may be, for example, an organic light-emitting diode (organic light-emitting diode, OLED) display panel or a quantum dot light emitting diode (quantum dot light emitting diodes, QLED) display panel.

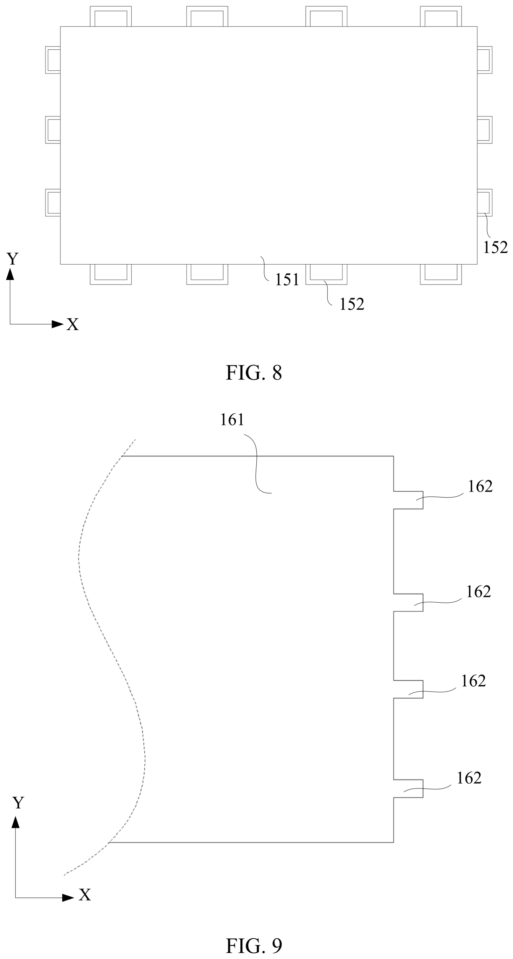

The optical film 150 provided in this embodiment of this application is configured to uniformize light that passes through the diffuser plate 160, to improve display effect of the display panel 110. FIG. 8 is a diagram of a structure of an optical film according to an embodiment of this application. In addition, with reference to FIG. 4 and FIG. 5 and with reference to FIG. 8, the optical film 150 provided in this embodiment of this application includes a first body 151 and a plurality of mounting ears 152, the plurality of mounting ears 152 are disposed around the first body 151 and spaced apart along a circumferential direction of the first body 151, and each mounting ear 152 and the first body 151 jointly define the mounting hole for inserting the mounting plate portion 173. Certainly, the mounting ears 152 may alternatively be disposed on two opposite sides of the first body 151 or disposed on three sides of the first body 151.

The diffuser plate 160 provided in this embodiment of this application is configured to diffuse and uniformize light emitted by a light source of the electronic device, to improve display effect of the display panel 110. FIG. 9 is a diagram of a structure of a diffuser plate according to an embodiment of this application. In addition, with reference to FIG. 5 and FIG. 5 and with reference to FIG. 9, the diffuser plate 160 provided in this embodiment of this application includes a second body 161 and a plurality of convex lugs 162, and the plurality of convex lugs 162 are disposed around the second body 161 and are of an integral structure with the second body 161. Certainly, in some embodiments, the convex lug 162 may alternatively be removed from the diffuser plate 160.

The reflector plate 190 provided in this embodiment of this application is configured to reflect light.

As shown in FIG. 3, the frame 120 provided in this embodiment of this application is disposed on a ground-facing side (or referred to as a bottom side) of the display panel 110. Therefore, in this embodiment of this application, the frame 120 is a ground facing-side frame, and the ground facing-side frame may also be referred to as a trim strip. Certainly, frames may alternatively be disposed on a left side and a right side of the display panel 110, or even on a sky-facing side. Therefore, in some embodiments, the frame 120 may alternatively include at least one of the ground facing-side frame, a sky facing-side frame, a left-side frame, and a right-side frame.

As shown in FIG. 3, the middle frame 200 provided in this embodiment of this application surrounds three sides of the display panel 110 other than the ground-facing side, namely, a top side, a left side, and a right side.

With reference to the accompanying drawings, the following describes in detail the structure of the electronic device provided in this embodiment of this application.

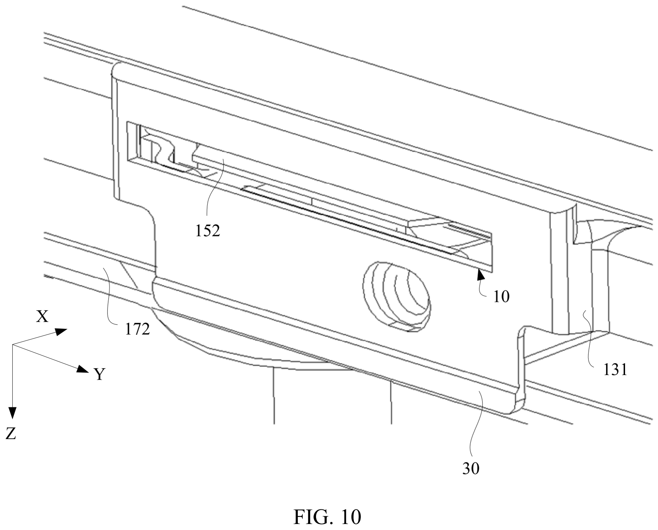

FIG. 10 is a diagram of a first partial three-dimensional structure of the electronic device in the embodiment shown in FIG. 3. With reference to FIG. 4 to FIG. 9 and with reference to FIG. 10, the electronic device in this embodiment of this application includes the display panel 110, the diffuser plate 160, the optical film 150, the support member 130, the backplane 170, the frame 120, and a plurality of avoidance structures 10. The support member 130 includes the first portion 131, the second portion 132, and the third portion 133; the first portion 131 and the second portion 132 are disposed on a same side of the third portion 133 and spaced apart along the first direction; along the second direction (the Z direction in FIG. 4 or FIG. 5), the third portion 133 is disposed between the display panel 110 and the optical film 150; and the second portion 132 includes a plurality of first notches 134. The optical film 150 includes the first body 151 and the plurality of mounting ears 152, and each mounting ear 152 and the first body 151 jointly define one mounting hole. The backplane 170 includes the first main body portion 171, the folded edge portion 172, and the mounting plate portion 173; the folded edge portion 172 is disposed at the edge of the first main body portion 171 and is located between the first portion 131 and the second portion 132; and the mounting plate portion 173 is disposed between the folded edge portion 172 and the diffuser plate 160 along the first direction and is disposed inside the mounting hole. The display panel 110, the optical film 150, and the diffuser plate 160 are disposed on a same side of the first main body portion 171 and are sequentially stacked along the second direction. The first portion 131 is disposed between the folded edge portion 172 and the frame 120, and along the first direction, a projection of the first portion 131 overlaps each of a projection of the folded edge portion 172 and a projection of the frame 120. One part of each avoidance structure 10 is disposed on the folded edge portion 172, and the other part is disposed on the first portion 131. Each avoidance structure 10 defines an avoidance space used to accommodate at least a part of the corresponding mounting ear 152. Each mounting ear 152 corresponds to one avoidance structure 10 and one first notch 134, and at least a part of each mounting ear 152 is disposed, through the corresponding first notch 134, inside the avoidance space defined by the corresponding avoidance structure 10. Along the first direction, an expansion gap exists between each mounting ear 152 and the frame 120. The first direction is perpendicular to the second direction. In addition, in this embodiment of this application, a thickness direction of the display panel 110 is defined as the second direction.

First, as shown in FIG. 1, in a related technology, a spacing between a mounting ear of an optical film 17 and a frame 12 is L=A+B+C+D+E+F, and a width of the frame 12 is M=G+H. A is an expansion gap of the optical film 17, B is a thickness of a part that is of a plastic frame 13 and that is located between the mounting ear of the optical film 17 and a folded edge portion 182, C is a spacing between the plastic frame 13 and the folded edge portion 182, D is a thickness of the folded edge portion 182, E is a spacing between the folded edge portion 182 and the frame 12, F is a thickness of a part that is of the frame 12 and that is opposite to the folded edge portion 182, G is a lapping width between the frame 12 and a display panel 11, and H is a spacing between the display panel 11 and the frame 12.

However, as shown in FIG. 5, in this embodiment of this application, along the first direction (for example, the X direction in FIG. 5), a projection of the mounting ear 152 does not overlap the projection of the folded edge portion 172 and the projection of the first portion 131. Therefore, a spacing between the mounting ear 152 and the frame 120 is L=A+F, and a width of the frame 120 is M=G+H. It can be learned that, in this embodiment of this application, B, C, D, and E are removed, so that the spacing L becomes smaller. In this way, it is equivalent to that the frame 120 is moved leftward (FIG. 5 is used as an example), and Moving distance=B+C+D+E. Further, when a lapping width G between the frame 120 and the display panel 110 remains unchanged, the spacing H is reduced, and a reduced value may be exactly equal to the moving distance of the frame 120. Therefore, the width M of the frame 120 is reduced.

In conclusion, in the electronic device, the avoidance structure 10 that defines the avoidance space used to accommodate the mounting ear 152 is disposed on the folded edge portion 172 and the first portion 131, so that both the folded edge portion 172 and the first portion 131 are decoupled from the expansion gap of the mounting ear 152, and when the optical film 150 is expanded, enough space may be available to accommodate the mounting ear 152. In this way, a spacing between the optical film 150 and the frame 120 in the first direction can be reduced, and a width of the frame 120 in the first direction can be reduced, to improve delicacy of an appearance of the electronic device.

Still refer to FIG. 5. In this embodiment of this application, each avoidance structure 10 includes a first substructure 101 and a third substructure 102. Along the first direction, the first substructure 101 is disposed on the folded edge portion 172, the third substructure 102 is disposed on the first portion 131, the first substructure 101 defines a first space, the third substructure 102 defines a second space, and the first space and the second space communicate and jointly define the avoidance space. In this way, when the optical film 150 is expanded, an enough space can be provided to accommodate the mounting ear 152. In this way, the width of the frame 120 in the first direction is reduced.

Still refer to FIG. 3. The first substructure 101 includes a through notch, and an inner wall of the through notch defines the first space. Along the second direction, the inner wall of the through notch is lower than a bottom end surface of the mounting ear 152, so that the folded edge portion 172 is decoupled from the mounting ear 152. In other words, the folded edge portion 172 does not interfere with each mounting ear 152 in the second direction. In addition, a specific shape of the through notch is not limited herein.

Certainly, in some embodiments, the first substructure 101 may further include a through opening (not shown in the figure), the through opening penetrates through the folded edge portion 172 along the first direction, and an inner wall of the through opening defines the first space. The through opening may include but is not limited to a circular hole, a square hole, an elliptical hole, or the like.

In conclusion, when the first substructure 101 is a through notch or the through opening, the first space that accommodates the mounting ear 152 may be defined, so that the folded edge portion 172 is decoupled from the expansion gap of the mounting ear 152, to reduce the width of the frame 120. However, when the first substructure 101 is a through notch, difficulty in disposing the first substructure 101 on the folded edge portion 172 may be reduced, and processing efficiency of the backplane 170 may be further improved.

With reference to FIG. 5 and FIG. 10, the third substructure 102 includes a through hole, the through hole penetrates through the first portion 131 along the first direction, an inner wall of the through hole defines the second space, and the second space and the first space communicate and are used to accommodate a part of the mounting ear 152. The through hole may include but is not limited to a circular hole, an elliptical hole, a polygonal hole, or the like. For example, as shown in FIG. 10, the through hole is a rectangular hole.

Certainly, in some embodiments, the third substructure 102 may further include a through notch (not shown in the figure), the through notch penetrates through the first portion 131 along the first direction, and an inner wall of the through notch defines the second space.

In conclusion, when the third substructure 102 is a through notch or the through hole, the second space that accommodates the mounting ear 152 may be defined, so that the first portion 131 is decoupled from the expansion gap of the mounting ear 152, to reduce the width of the frame 120. However, when a second through structure is a through hole, strength of the support member 130 may be further improved, to prevent the support member 130 from being deformed.

With reference to FIG. 4, the first main body portion 171 includes a first portion body 1711 and a second portion body 1712. An included angle between the first portion body 1711 and the second portion body 1712 is a corner angle. Correspondingly, the included angle between the first portion body 1711 and the second portion body 1712 is set to a corner angle. In this way, while an effective lapping width between the diffuser plate 160 and the backplane 170 is ensured, a spacing between the frame 120 and the folded edge portion 172 can be reduced, and the width of the frame 120 can be further reduced on the basis that the width of the frame 120 is reduced by using the avoidance structure 10.

An objective of ensuring the effective lapping width between the diffuser plate 160 and the backplane 170 is to avoid a gap between the diffuser plate 160 and the main body portion when the diffuser plate 160 shrinks, to prevent light from passing through the gap between the diffuser plate 160 and the main body portion, that is, prevent light from being leaked through the gap between the diffuser plate 160 and the main body portion.

The corner angle is an intersection (or a transition) between a surface of the first portion body 1711 and a surface of the second portion body 1712, and the intersection is a line. In other words, the surface of the first portion body 1711 and the surface of the second portion body 1712 intersect on a line instead of a surface. In addition, it may also be understood that on a longitudinal section of the first main body portion 171, the surface of the first portion body 1711 and the surface of the second portion body 1712 intersect at a point, and the point is a point in the foregoing line.

The corner angle between the first portion body 1711 and the second portion body 1712 is greater than 0° and less than 180°. In addition, a specific value of the corner angle between the first portion body 1711 and the second portion body 1712 is not limited herein.

Still refer to FIG. 4. Along the second direction, the first portion body 1711 includes a first surface A1 and a second surface A2 that are oppositely disposed, and the second portion body 1712 includes a third surface A3 and a fourth surface A4 that are oppositely disposed. The first surface A1 intersects the third surface A3, and the second surface A2 intersects the fourth surface A4. An included angle between the first surface A1 and the third surface A3 is a first included angle R1, an included angle between the second surface A2 and the fourth surface A4 is a second included angle R2, and at least one of the first included angle R1 and the second included angle R2 is a corner angle. For example, the first included angle R1 may be a corner angle and the second included angle R2 may be a rounded angle, or the first included angle R1 may be a rounded angle and the second included angle R2 may be a corner angle, or the first included angle R1 and the second included angle R2 each may be a corner angle.

Setting at least one of the first included angle R1 and the second included angle R2 to a corner angle may further reduce the width of the frame 120. Certainly, setting one of the first included angle R1 and the second included angle R2 to a corner angle and setting the other one to a rounded angle may reduce processing difficulty of the backplane 170. In this embodiment of this application, an example in which the first included angle R1 is a rounded angle and the second included angle R2 is a corner angle is used for description.

First, as shown in FIG. 2, in the related technology, there is a relational expression 1: P+N+K=R+H. Along the first direction, P is a spacing between a boundary line W and a reference line Q of the display panel 11, N is an effective lapping width between a diffuser plate 14 and a backplane 18, K is a spacing between the diffuser plate 14 and the frame 12, and R is a width of a non-display area of the display panel 11. In addition, the boundary line W is a boundary line between a display area and the non-display area of the display panel 11, and the reference line Q is a reference for determining the effective lapping width between the diffuser plate 14 and the main body portion 181.

However, as shown in FIG. 4, in this embodiment of this application, there is a relational expression 2: N+K=R+H. It can be learned that, in this embodiment of this application, the spacing P is removed, so that a sum of R and H in the relational expression 2 is less than a sum of R and H in the relational expression 1. In addition, because the spacing R is a fixed value, when the spacing H becomes smaller, the frame 120 moves toward the display panel 110 along the first direction, so that the lapping width G between the frame 120 and the display panel 110 can become larger. However, if the lapping width G is maintained unchanged, the width M of the frame 120 may be reduced. Therefore, when the lapping width between the frame 120 and the display panel 110 is maintained unchanged on the basis that the width of the frame 120 is reduced by using the avoidance structure 10, setting at least one of the first included angle R1 and the second included angle R2 to a corner angle may further reduce the width of the frame 120.

Still refer to FIG. 4, the reference line Q coincides with the boundary line W. In other words, a value of the spacing P is 0. Certainly, a value of the spacing P may not be zero. In other words, the boundary line W does not coincide with the reference line Q. In this case, there is a spacing between the boundary line W and the reference line Q. Along the first direction, when the reference line Q is located between the boundary line W and the folded edge portion 172, the spacing between the reference line Q and the boundary line W is less than the spacing shown in FIG. 1. When the boundary line W is located between the reference line Q and the folded edge portion 172, a spacing between the boundary line W and the folded edge portion 172 may be greater than or less than the spacing P shown in FIG. 1.

In this embodiment of this application, the second included angle R2 is always used as a reference of the reference line Q. When the second included angle R2 is a corner angle, the reference line Q intersects with an intersection line of the third surface A3 and the fourth surface A4 at one point. When the second included angle R2 is a rounded angle, the reference line Q intersects with a center of the rounded angle.

With reference to FIG. 4, FIG. 6, FIG. 7, and FIG. 9, the second portion 132 further includes a plurality of second notches 135. The plurality of second notches 135 and the plurality of first notches 134 are disposed side by side along a third direction (a Y direction in FIG. 7, FIG. 8, or FIG. 9), the plurality of second notches 135 are spaced apart along the third direction, and each second notch 135 corresponds to one convex lug 162 and is configured to accommodate at least a part of the corresponding convex lug 162. For example, in FIG. 4, the convex lug 162 is disposed inside the corresponding second notch 135. In addition, in FIG. 7, the plurality of second notches 135 and the plurality of first notches 134 are alternately arranged along the third direction, or may not need to be alternately arranged. The first direction, the second direction, and the third direction are perpendicular to each other. In addition, in this embodiment of this application, because the frame 120 is a ground facing-side frame, the third direction may be defined as a length direction of the ground facing-side frame.

First, as shown in FIG. 2, in the related technology, along the first direction, a projection of a convex lug of the diffuser plate 14 partially overlaps a projection of the plastic frame 13. In other words, the convex lug of the diffuser plate 14 and the plastic frame 13 are spaced apart, so that a spacing between the convex lug of the diffuser plate 14 and the frame 12 is coupled to the plastic frame 13.

However, as shown in FIG. 4, in this embodiment of this application, a part of the convex lug 162 is disposed inside the second notch 135. In other words, along the first direction, a projection of the convex lug 162 does not overlap a projection of the second portion 132. In this way, a spacing between the convex lug 162 and the frame 120 is decoupled from the second portion 132, so that when the spacing between the convex lug 162 and the frame 120 becomes smaller, the frame 120 may move toward the display panel 110 along the first direction. Therefore, the width of the frame 120 may be further reduced while the lapping width between the frame 120 and the display panel 110 remains unchanged.

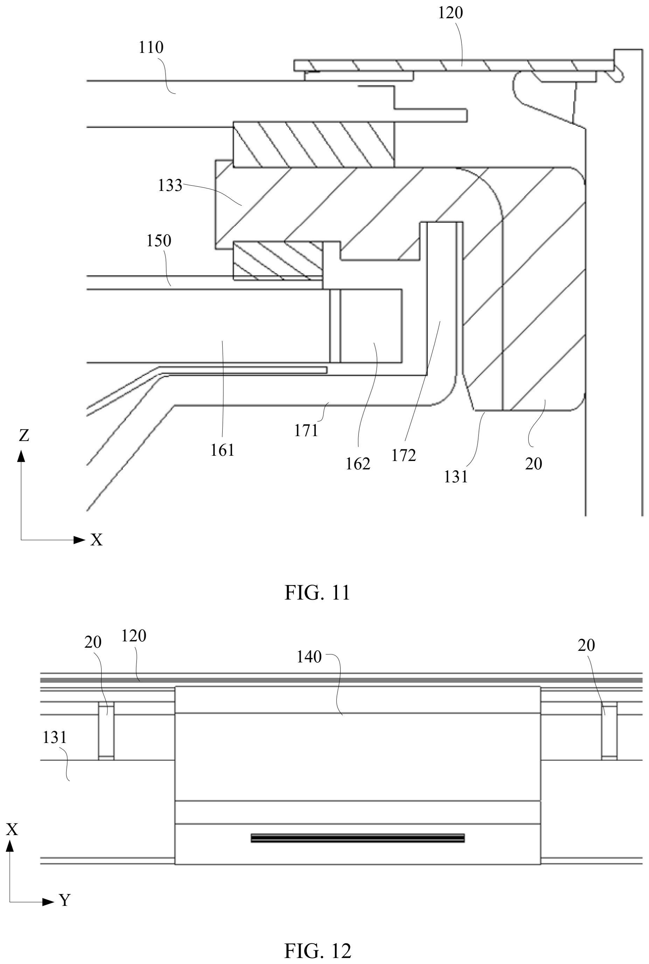

FIG. 11 is a third partial sectional view of the electronic device in the embodiment shown in FIG. 3. FIG. 12 is a diagram of a second partial three-dimensional structure of the electronic device in the embodiment shown in FIG. 3. With reference to FIG. 4 and with reference to FIG. 11 and FIG. 12, the electronic device in this embodiment of this application further includes a plurality of support structures 20 and a plurality of chips on film 140. The plurality of chips on film 140 are arranged side by side and spaced apart along the third direction (for example, a Y direction in FIG. 12). The plurality of support structures 20 are disposed between the frame 120 and the first portion 131 along the first direction, and two opposite ends of each support structure 20 along the first direction are respectively in contact with the frame 120 and the first portion 131. Along the third direction, the plurality of support structures 20 are arranged side by side and spaced apart, a gap between two adjacent support structures 20 is used for passing through by one chip on film 140, and a gap exists between the chip on film 140 and the adjacent support structures 20.

A size of the chip on film space jointly defined by the first portion 131 and the frame 120 in the first direction may be set to an extreme size (or referred to as a minimum size). In this way, the frame 120 may move toward the display panel 110 along the first direction, and the width of the frame 120 may be further reduced when the lapping width between the frame 120 and the display panel 110 is maintained unchanged. The chip on film space is a gap jointly defined by the frame 120 and the support member 130 in the first direction. In addition, the frame 120 and the support member 130 jointly define a plurality of chip on film spaces, and each chip on film space corresponds to one chip on film 140. In addition, in this embodiment of this application, the extreme size of the chip on film space is not limited herein. The extreme size of the chip on film space needs to meet two requirements that the chip on film 140 is flexible and may move freely.

When the size of the chip on film space is the extreme size, the frame 120 and/or the support member 130 may deform and squeeze the chip on film 140 in a shaking process of the electronic device, damaging the chip on film 140. However, because the support structure 20 is disposed between the frame 120 and the first portion 131, deformation of the support member 130 and/or the frame 120 may be controlled to be within a preset range. In this way, the chip on film 140 can be prevented from being damaged due to deformation of the support member 130 and/or the frame 120. Therefore, the support structure 20 is disposed between the frame 120 and the first portion 131. In this way, not only the size of the chip on film space can be set to the extreme size, to further reduce the width of the frame 120, but also the chip on film 140 can be further prevented from being damaged in the shaking process of the electronic device.

Still refer to FIG. 12. Along the third direction, a gap exists between the chip on film 140 and the adjacent support structures 20, to avoid damaging the chip on film 140 when the electronic device shakes and because the support structure 20 is in contact with the chip on film 140. Along the third direction, a spacing between the chip on film 140 and the adjacent support structures 20 is greater than or equal to 5 mm, to ensure that the chip on film 140 is not in contact with the support structures 20 when the electronic device shakes. Certainly, in some embodiments, the spacing between the chip on film 140 and the adjacent support structures 20 may alternatively be less than 5 mm.

In this embodiment of this application, when the electronic device does not shake, the support structure 20 is in contact with each of the support member 130 and the frame 120, to further reduce the size of the chip on film space in the first direction, and further reduce the width of the frame 120. Certainly, in some embodiments, when the electronic device does not shake, the support structure 20 may alternatively be in contact with one of the support member 130 and the frame 120; or in some embodiments, when the electronic device does not shake, the support structure 20 may be in contact with neither the support member 130 nor the frame 120.

Still refer to FIG. 11 and FIG. 12. Each support structure 20 includes a support rib. The support rib is disposed between the first portion 131 and the frame 120 and is in contact with each of the first portion 131 and the frame 120. The first portion 131 and the support rib are of an integral structure.

Certainly, in an embodiment, each support rib may alternatively be of an integral structure (not shown in the figure) with the frame 120. Alternatively, in an embodiment, each support rib is of a split structure (not shown in the figure) with each of the support member 130 and the frame 120. In other words, each support rib is of an independent structure, and each support rib is inserted between the first portion 131 and the frame 120 and is detachably connected to each of the first portion 131 and the frame 120.

In conclusion, the support rib is of an integral structure with one of the first portion 131 and the frame 120, or the support rib is inserted between the first portion 131 and the frame 120, to avoid damaging the chip on film 140 when the electronic device shakes, and further reduce the width of the frame 120. However, setting the support rib and the first portion 131 to be of an integral structure may reduce difficulty in disposing the support rib, and may further improve production efficiency of the electronic device.

In this embodiment of this application, a specific structure of the support rib is not limited herein. For example, as shown in FIG. 10, each support rib may be of a plate-shaped structure.

With reference to FIG. 4 and FIG. 5, the electronic device in this embodiment of this application further includes a non-transparent bonding member 180. Along the second direction, the display panel 110 and the first portion 131 are respectively disposed on two opposite sides of the third portion 133, a part of the display panel 110 is disposed between the frame 120 and the third portion 133, and the bonding member 180 is disposed between the third portion 133 and the display panel 110 and is bonded to each of the third portion 133 and the display panel 110.

It can be learned from FIG. 4 and FIG. 5 that the width of the frame 120 is M=G+H. Therefore, it can be learned that when H remains unchanged, a smaller lapping width G between the frame 120 and the display panel 110 leads to a smaller width M of the frame 120. However, when the lapping width between the frame 120 and the display panel 110 is small, problems such as screen flickering and light transmission easily occur. Screen flickering means that a state in which a part of the display panel 110 is located between the third portion 133 and the frame 120 changes to a state in which a part of the frame 120 is located between the display panel 110 and the third portion 133. Light transmission means that light inside the electronic device is emitted through a gap between the display panel 110 and the third portion 133. Therefore, when the lapping width between the frame 120 and the display panel 110 is reduced, the display panel 110 is connected to the support member 130 through the non-transparent bonding member 180. In this way, not only the display panel 110 can be fastened to the support member 130 to avoid screen flickering, but also light transmission can be further avoided. Therefore, connecting the display panel 110 and the support member 130 through the bonding member 180 not only can avoid light transmission and/or screen flickering, but also can further reduce the width of the frame 120.

In this embodiment of this application, along the first direction, the lapping width between the display panel 110 and the frame 120 is greater than or equal to 1 mm, and the lapping width between the display panel 110 and the frame 120 is less than or equal to 3 mm. For example, the lapping width between the display panel 110 and the frame 120 may be 2 mm.

Certainly, in an embodiment, the lapping width between the display panel 110 and the frame 120 may alternatively be greater than 3 mm.

In conclusion, the lapping width between the display panel 110 and the frame 120 in the first direction is greater than or equal to 1 mm and less than or equal to 3 mm, so that the lapping width between the frame 120 and the display panel 110 is very small. In this way, the width of the frame 120 in the first direction can be further reduced, and the width of the frame 120 can be designed to be extremely narrow.

In this embodiment of this application, the bonding member 180 includes a double-sided foam tape. In this way, not only the width of the frame 120 in the first direction can be further reduced, but also the display panel 110 can be further separated from the support member 130, to repair or replace the display panel 110.

Certainly, in addition to the double-sided foam tape, the bonding member 180 of another structure may alternatively be used. This is not limited herein.

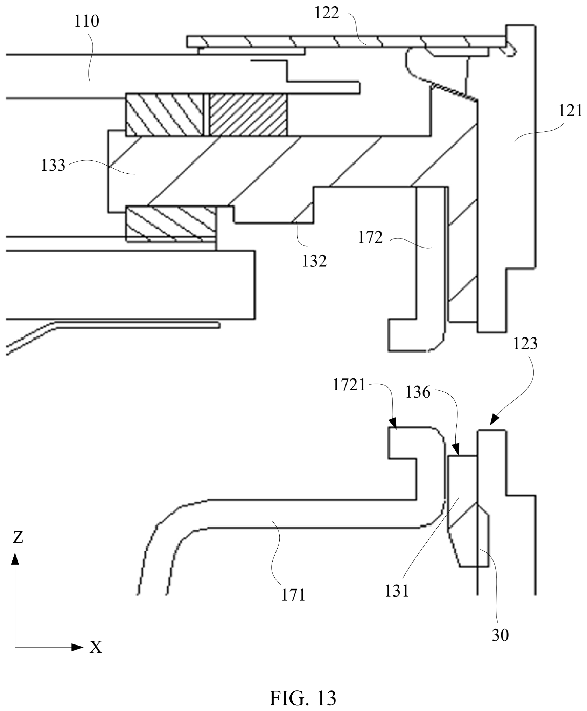

FIG. 13 is a fourth partial sectional view of the electronic device in the embodiment shown in FIG. 3. With reference to FIG. 5 and FIG. 10 and with reference to FIG. 13, the electronic device in this embodiment of this application further includes a plurality of eccentric structures 30. The plurality of eccentric structures 30 are disposed between the frame 120 and the first portion 131 along the first direction, and the plurality of eccentric structures 30 are arranged side by side and spaced apart along the third direction. Along the first direction, each eccentric structure 30 is in contact with each of the frame 120 and the first portion 131, so that the frame 120 rotates around a rotation axis parallel to the third direction and toward the display panel 110 by a specific angle. In other words, under an action of the eccentric structure 30, a top end surface of the frame 120 in the second direction is no longer parallel to a display surface of the display panel 110, and the top end surface of the frame 120 intersects with and is not perpendicular to the display surface of the display panel 110.

As shown in FIG. 13, the eccentric structure 30 is disposed between the frame 120 and the first portion 131 and is in contact with each of the frame 120 and the support member 130, so that the frame rotates around the rotation axis and toward the display panel 110 by a specific angle. In this way, the gap between the frame 120 and the display panel 110 can be reduced or even to zero, and delicacy of the appearance of the electronic device can be further improved.

With reference to FIG. 10 and FIG. 13, each eccentric structure 30 includes an eccentric rib, and the eccentric rib is disposed between the frame 120 and the first portion 131 along the first direction and is of an integral structure with the first portion 131.

Certainly, in some embodiments, each eccentric rib may alternatively be of an integral structure with the frame 120 (not shown in the figure); or in some embodiments, each eccentric rib may alternatively be of a split structure with the frame 120 and the support member 130 (not shown in the figure). In other words, each eccentric rib is an independent part and is detachably inserted between the frame 120 and the first portion 131.

In conclusion, the eccentric rib is of an integral structure with one of the first portion 131 and the frame 120, or is detachably inserted between the frame 120 and the first portion 131, so that the frame 120 can rotate around the rotation axis and toward the display panel 110 by a specific angle. In this way, the gap between the frame 120 and the display panel 110 can become smaller, and delicacy of the appearance of the electronic device can be further improved. However, setting the support member 130 and the eccentric rib to be of an integral structure may reduce difficulty in disposing the eccentric structure 30, and may further improve production efficiency of the electronic device.

A specific structure of the eccentric rib is not limited herein. For example, as shown in FIG. 10, the eccentric rib may be of a strip structure extending along the third direction.

Still refer to FIG. 13. The folded edge portion 172 includes a plurality of threaded holes 1721, the first portion 131 includes a plurality of via holes 136, the frame 120 includes a plurality of fastening holes 123, and the electronic device further includes a plurality of fasteners (not shown in the figure). The plurality of fasteners are arranged side by side and spaced apart along the third direction, and each fastener corresponds to one fastening hole 123, one via hole 136, and one threaded hole 1721. The plurality of fastening holes 123 are disposed side by side and spaced apart along the first direction, each fastening hole 123 is an eccentric hole and penetrates through the frame 120 along the first direction, and an axis of each fastening hole 123 is parallel to the first direction. Each fastener is disposed inside the corresponding fastening hole 123, via hole 136, and threaded hole 1721, one end of each fastener is threadedly connected to the folded edge portion 172, and the other end of each fastener is connected to the frame 120, so that the frame 120 is fastened to the folded edge portion 172.

Still refer to FIG. 13. Because the eccentric structure 30 is disposed between the frame 120 and the support member 130, so that the frame 120 rotates around the rotation axis and toward the display panel 110, an axis of the fastening hole 123 intersects with the first direction and is not perpendicular to the first direction. In this case, the axis of the fastening hole 123 no longer coincides with an axis of the via hole 136 and an axis of the threaded hole 1721. Consequently, the fastener cannot be inserted into the threaded hole 1721 and the via hole 136, or it is difficult to insert the fastener into the threaded hole 1721 and the via hole 136, increasing assembly difficulty of the fastener. Therefore, in this embodiment of this application, the fastening hole 123 is disposed as an eccentric hole. When the eccentric structure 30 is disposed between the eccentric frame 120 and the support member 130, the axis of the fastening hole 123 may alternatively be parallel to the first direction. In this way, after the frame 120 rotates by a specific angle, the axis of the fastening hole 123 may alternatively coincide with an axis of the threaded hole 1721, to reduce difficulty in fastening the folded edge portion 172 and the frame 120 by the fastener.

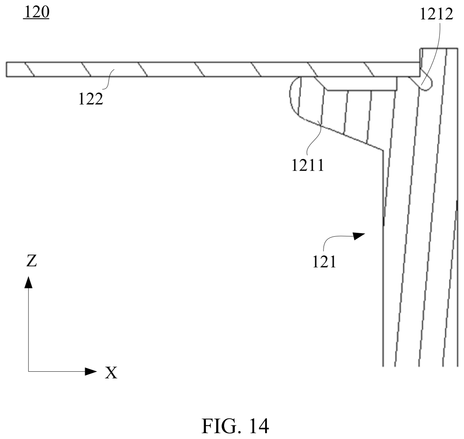

FIG. 14 is a partial sectional view of a frame of the electronic device in the embodiment shown in FIG. 3. In this embodiment of this application, with reference to FIG. 4 or FIG. 5 and with reference to FIG. 14, the frame 120 includes a second main body portion 121 and a support plate portion 122. The support plate portion 122 is of a rectangular plate-shaped structure. One end of the support plate portion 122 is detachably connected to the second main body portion 121, and the other end of the support plate portion 122 laps with a surface that is of the display panel 110 and that faces away from the optical film 150 along the second direction. The first portion 131 is disposed between the second main body portion 121 and the folded edge portion 172. In this way, not only flatness of the support plate portion 122 can be better controlled, to further improve delicacy of the appearance of the electronic device, but also a thickness of the support plate portion 122 can be further reduced, to implement a thin design. In addition, support plate portions 122 made of different materials may alternatively be used, which brings different appearance experience to a user.

The support plate portion 122 in this embodiment of this application is a stainless steel plate portion. In other words, the support plate portion 122 is made of a stainless steel sheet, and there is no forming stress, so that flatness can be better controlled, appearance effect after assembly can be ensured, a side surface is flatter, and delicacy of the appearance is improved. In addition, the thickness of the support plate portion 122 in the second direction may be further reduced, to implement an extreme thin design.

Certainly, in addition to the stainless steel plate portion, the support plate portion 122 may alternatively be made of another material, for example, may include but is not limited to a plastic plate portion, an aluminum plate portion, a carbon fiber plate portion, a vinyl chloride plate portion, a PCM plate portion, or a polycarbonate plate portion, which may bring different appearance experience to the user.

The support plate portion 122 may be detachably connected to the second main body portion 121 through bonding. Certainly, the support plate portion 122 may alternatively be detachably connected to the second main body portion 121 in another manner.

A material of the second main body portion 121 may be an aluminum strip, and certainly, may be another material.

A specific structure of the second main body portion 121 is not limited herein. For example, still as shown in FIG. 14, along the second direction, an end that is of the second main body portion 121 and that faces the support plate portion 122 includes an anti-overflow adhesive stopper 1211 and a positioning groove 1212. Along the second direction, a top end surface of the anti-overflow adhesive stopper 1211 is in contact with a bottom end surface of the support plate portion 122, the top end surface of the anti-overflow adhesive stopper 1211 and the bottom end surface of the support plate portion 122 define an accommodation cavity, and the accommodation cavity is configured to accommodate glue for bonding the support plate portion 122 and the second main body portion 121. A part of one end of the support plate portion 122 is disposed inside the positioning groove 1212. Correspondingly, the anti-overflow adhesive stopper 1211 fits the support plate portion 122, so that the support plate portion 122 and the second main body portion 121 can be fastened through dispensing. In addition, the glue may be blocked and/or the glue may be prevented from overflowing, thereby improving aesthetics of the electronic device. In addition, a part of one end of the support plate portion 122 is inserted into the positioning groove 1212, to ensure a relative position of the support plate portion 122 and the second main body portion 121.

In the foregoing content, the support plate portion 122 is of a rectangular plate-shaped structure. However, the support plate portion 122 may alternatively be of another structure. For example, in an embodiment, the support plate portion 122 may also be of plate-shaped structure of an "L" shape.

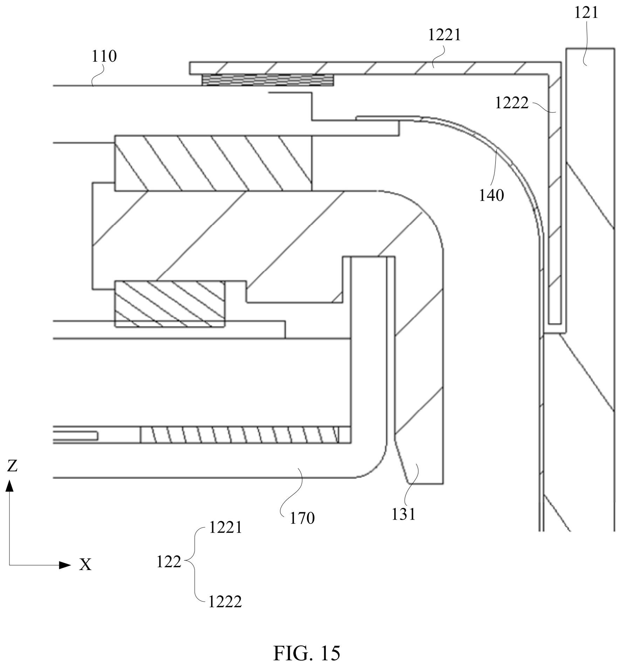

FIG. 15 is a partial sectional view of a second electronic device according to an embodiment of this application. A difference between FIG. 15 and FIG. 4 lies in that, a cross section of the support plate portion 122 is of an "L" shape, the support plate portion 122 includes a first support plate section 1221 and a second support plate section 1222, an included angle exists between the first support plate section 1221 and the second support plate section 1222, a first end of the first support plate section 1221 is configured to lap with a surface that is of the display panel 110 and that faces away from the optical film 150 along the second direction, a second end of the first support plate section 1221 is connected to a first end of the second support plate section 1222, and a second end of the second support plate section 1222 is detachably connected to the second main body portion 121. The included angle between the first support plate section 1221 and the second support plate section 1222 is a right angle.

As shown in FIG. 15, to avoid coupling between the width of the frame 120 and a structure of the support plate portion 122, the second main body portion 121 includes a connection notch for accommodating the second support plate section 1222, and along the first direction, a thickness of the second support plate section 1222 is less than a depth of the connection notch, so that a connection structure of the second main body portion 121 and the support plate portion 122 does not limit the width of the frame 120.

As shown in FIG. 15, the second support plate section 1222 may be connected to the second main body portion 121 by using a double-sided tape, to reduce difficulty in connecting the support plate portion 122 to the second main body portion 121. Certainly, the second support plate section 1222 may alternatively be connected to the second main body portion 121 in another manner.

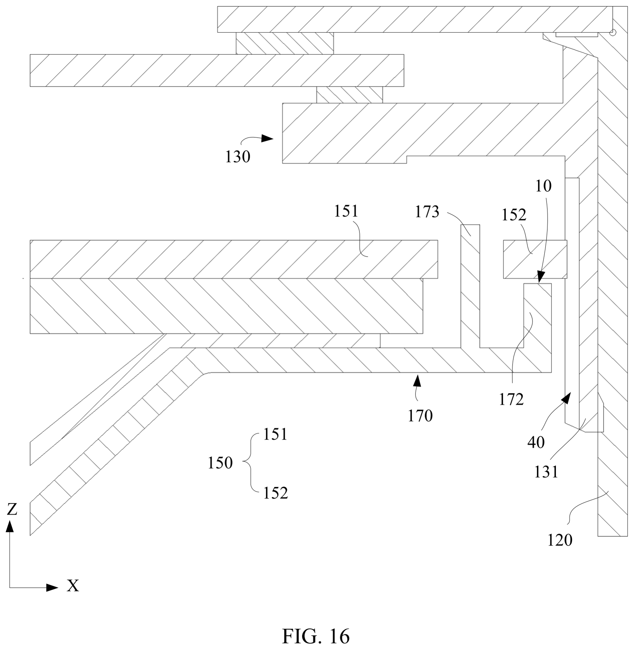

FIG. 16 is a partial sectional view of a third electronic device according to an embodiment of this application. A difference between FIG. 16 and FIG. 5 lies in that, each avoidance structure 10 includes the first substructure 101 and the second substructure, the first substructure 101 is disposed on the folded edge portion 172 and defines the first space, the second substructure is disposed on the first portion 131 and defines a groove space 40, the first space and the groove space 40 jointly define the avoidance space, the groove space 40 is used to accommodate a part that is of the mounting ear 152 and that passes through the first space, and along the first direction, an expansion gap exists between each mounting ear 152 and a groove bottom of the corresponding groove space 40, and a groove opening of each groove space 40 faces the corresponding mounting ear 152. Correspondingly, the avoidance space and the groove space 40 fit each other, so that the folded edge portion 172 and a part of the first portion 131 can be decoupled from the mounting ear 152. In other words, the expansion gap of the mounting ear 152 is decoupled from the folded edge portion 172 and a part of the first portion 131. In this way, the width of the frame 120 in the first direction can be reduced, and delicacy of the appearance of the electronic device can be improved.

As shown in FIG. 16, in this embodiment of this application, the groove space 40 may be understood as disposing a groove on a surface that is of the first portion 131 and that faces the mounting ear 152 along the first direction, in other words, thinning a part of the first portion 131. Therefore, compared with FIG. 5, in FIG. 16, the groove space 40 defined by the second substructure does not penetrate through the first portion 131 along the first direction, and the second space in FIG. 5 is of a hollow structure and penetrates through the first portion 131 along the first direction. Therefore, the groove space 40 enables a part of the first portion 131 to be decoupled from the expansion gap of the mounting ear 152.

As shown in FIG. 16, the groove space 40 includes the groove bottom and a plurality of groove side walls. Along the first direction, the plurality of groove side walls are disposed on a same side of a groove and face the mounting ear. Along a circumferential direction of the groove bottom, the plurality of groove side walls are sequentially connected and define an annular structure having a notch. In other words, the plurality of groove side walls make a side wall of the groove space 40 similar to "U", "C", or a circular annular side wall having a notch. In addition, the notch may be lower than the mounting ear 152 along the second direction, so that the groove space 40 can be obtained by thinning a partial wall thickness of the first portion 131, thereby reducing difficulty in manufacturing the first portion 131.

Certainly, the plurality of groove side walls of the groove space 40 may alternatively form an annular side wall, that is, the side wall of the groove space 40 has no notch. In other words, the groove space 40 is equivalent to a blind hole disposed on the surface that is of the first portion 131 and that faces the mounting ear 152, for example, may include but is not limited to a round hole, a square hole, or an elliptical hole.

In the foregoing content, one part of each avoidance structure 10 is disposed on the folded edge portion 172, and the other part is disposed on the first portion 131. However, each avoidance structure 10 may alternatively be disposed on the folded edge portion 172, and defines an avoidance space used to accommodate at least a part of the corresponding mounting ear 152. The following describes the electronic device in which each avoidance structure 10 is disposed on the folded edge portion 172.

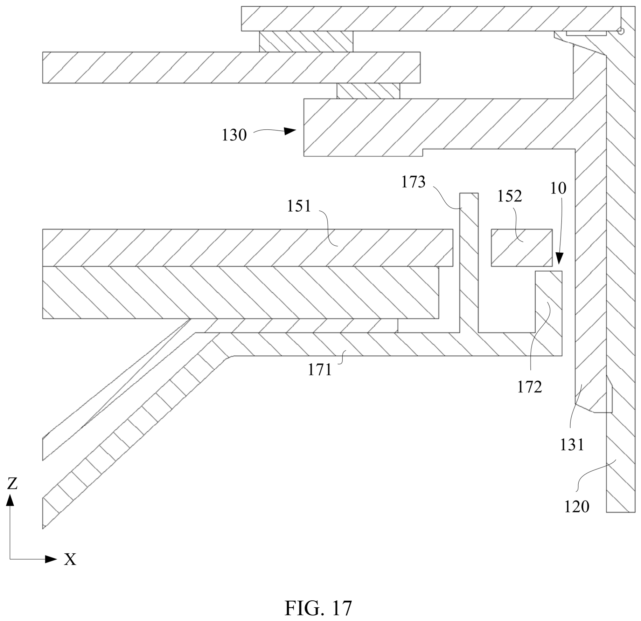

FIG. 17 is a partial sectional view of a fourth electronic device according to an embodiment of this application. A difference between FIG. 17 and FIG. 5 lies in that each avoidance structure 10 is disposed on the folded edge portion 172 and defines the avoidance space used to accommodate at least a part of the corresponding mounting ear 152. Along the first direction, an expansion gap exists between each mounting ear 152 and the first portion 131. In this way, the folded edge portion 172 can be decoupled from the expansion gap of the mounting ear 152, and the width of the frame 120 can also be reduced.

Still refer to FIG. 17. The avoidance structure 10 includes an avoidance notch, and the avoidance notch penetrates through the folded edge portion 172 along the first direction and defines the avoidance space. Certainly, the avoidance structure 10 may further include an avoidance hole (not shown in the figure), and the avoidance hole penetrates through the folded edge portion 172 along the first direction and is used to define the avoidance space.

Correspondingly, the avoidance structure 10 is an avoidance notch or an avoidance hole, so that the folded edge portion 172 is decoupled from the expansion gap of the mounting ear 152, thereby reducing the width of the frame 120 in the first direction, and further improving delicacy of the appearance of the electronic device. However, the avoidance notch is set to be of the avoidance structure 10, to reduce manufacturing difficulty of the backplane 170.

In conclusion, the width of the frame 120 may be reduced in the following several manners: In a first manner, a part of the avoidance structure 10 is disposed on the folded edge portion 172, the other part is disposed on the first portion 131, and an expansion gap exists between the frame 120 and the mounting ear 152. In a second manner, a part of the avoidance structure 10 is disposed on the folded edge portion 172, the other part is disposed on the first portion 131, and an expansion gap exists between the groove bottom of the groove space 40 and the mounting ear 152. In a third manner, the avoidance structure 10 is disposed on the folded edge portion 172, and an expansion gap exists between the mounting ear 152 and the first portion 131. In a fourth manner, an included angle between the first portion body 1711 and the second portion body 1712 of the first main body portion 171 is set to a corner angle. In a fifth manner, the second portion 132 includes the second notch 135 configured to accommodate the convex lug 162. In a sixth manner, the third portion 133 of the support member 130 is connected to the display panel 110 through the bonding member 180. In a seventh manner, the support structure 20 is disposed between the frame 120 and the first portion 131 of the support member 130. At a same moment, one of the first manner to the third manner exists. In addition, any one of the first manner to the third manner may alternatively be combined with at least one of the fourth manner to the seventh manner. For example, as shown in FIG. 3, the first manner, the fourth manner, the fifth manner, the sixth manner, and the seventh manner are combined. Certainly, the width of the frame 120 may alternatively be reduced by using any one of the first manner to the seventh manner.

It should be noted that, in addition to the foregoing several manners of reducing the width of the frame 120, a size of the mounting ear 152 may be further controlled. In other words, the size of the mounting ear 152 is set to an extreme size, to reduce a space required by the mounting ear 152 in the first direction, and reduce the width of the frame 120. Therefore, a manner of reducing the width of the frame 120 by controlling the size of the mounting ear 152 may be defined as an eighth manner. Correspondingly, any one of the first manner to the third manner may alternatively be combined with at least one of the fourth manner to the eighth manner, or the width of the frame 120 may be reduced by using one of the first manner to the eighth manner.

In descriptions of embodiments of this application, it should be noted that, unless otherwise clearly specified and limited, the term "installation", "interconnection", or "connection" should be understood in a broad sense, for example, may be fastening, may be an indirect connection through an intermediate medium, or may be an internal connection between two elements or an interaction relationship between two elements. A person of ordinary skill in the art may understand specific meanings of the foregoing terms in embodiments of this application based on specific cases.

In the specification, claims, and accompanying drawings of embodiments of this application, the terms "first", "second", "third", "fourth", and the like (if exist) are intended to distinguish between similar objects but do not necessarily indicate a specific order or sequence.

## Claims

1. An electronic device, comprising an optical film, a support member, a backplane, a frame, and at least one avoidance structure, wherein
the backplane comprises a folded edge portion, the support member comprises a first portion, and the optical film comprises at least one mounting ear;
along a first direction, the first portion is disposed between the folded edge portion and the frame; and
each avoidance structure corresponds to one mounting ear, at least a part of each avoidance structure is disposed on the folded edge portion, and each avoidance structure defines an avoidance space used to accommodate at least a part of the corresponding mounting ear.

2. The electronic device according to claim 1, wherein one part of each avoidance structure is disposed on the folded edge portion, and the other part is disposed on the first portion;
each avoidance structure comprises a first substructure and a second substructure, the first substructure is disposed on the folded edge portion and defines a first space, the second substructure is disposed on the first portion and defines a groove space, the first space and the groove space jointly define the avoidance space, and the groove space is used to accommodate a part that is of the mounting ear and that passes through the first space; and
along the first direction, an expansion gap exists between each mounting ear and a groove bottom of the corresponding groove space.

3. The electronic device according to claim 2, wherein the groove space comprises the groove bottom and a plurality of groove side walls;
along the first direction, the plurality of groove side walls are disposed on a same side of the groove bottom; and
along a circumferential direction of the groove bottom, the plurality of groove side walls are sequentially connected and define an annular structure having a notch.

4. The electronic device according to claim 1, wherein one part of each avoidance structure is disposed on the folded edge portion, the other part is disposed on the first portion, and along the first direction, an expansion gap exists between each mounting ear and the frame; and
each avoidance structure comprises a first substructure and a third substructure, the first substructure is disposed on the folded edge portion and defines a first space, the third substructure is disposed on the first portion and defines a second space, the first space and the second space jointly define the avoidance space, and the second space is used to accommodate a part that is of the mounting ear and that passes through the second space.

5. The electronic device according to claim 4, wherein the first substructure comprises a through notch, and an inner wall of the through notch defines the first space; or
the third substructure comprises a through hole, and an inner wall of the through hole defines the second space.

6. The electronic device according to claim 1, wherein each avoidance structure is disposed on the folded edge portion, and along the first direction, an expansion gap exists between each mounting ear and the first portion.

7. The electronic device according to claim 6, wherein each avoidance structure comprises an avoidance notch, and an inner wall of the avoidance notch defines the avoidance space; or
each avoidance structure comprises an avoidance hole, and an inner wall of the avoidance hole limits the avoidance space.

8. The electronic device according to any one of claims 1 to 7, wherein the backplane further comprises a first main body portion, and the folded edge portion is disposed on an edge of the first main body portion and is located on a same side of the first main body portion as the optical film; and
the first main body portion comprises a first portion body and a second portion body, and an included angle between the first portion body and the second portion body is a corner angle.

9. The electronic device according to claim 8, wherein along a second direction, the first portion body comprises a first surface and a second surface that are oppositely disposed, the second portion body comprises a third surface and a fourth surface that are oppositely disposed, and the first direction is perpendicular to the second direction;
the first surface intersects with the third surface, and the second surface intersects with the fourth surface; and
an included angle between the first surface and the third surface is a first included angle, an included angle between the second surface and the fourth surface is a second included angle, and at least one of the first included angle and the second included angle is a corner angle.

10. The electronic device according to any one of claims 1 to 7, wherein the support member further comprises a second portion, and along the first direction, the folded edge portion is disposed between the first portion and the second portion;
the second portion comprises a first notch and a second notch, the second notch and the first notch are arranged side by side and spaced apart along a third direction, and the first direction, the second direction, and the third direction are perpendicular to each other;
the second notch is used to accommodate at least a part of a convex lug of a diffuser plate; and
each mounting ear corresponds to one first notch, and each mounting ear is disposed inside the avoidance space through the corresponding first notch.

11. The electronic device according to any one of claims 1 to 7, wherein the electronic device further comprises a plurality of support structures;
along the first direction, the plurality of support structures are disposed between the frame and the first portion, and two opposite ends of each support structure are respectively in contact with the frame and the first portion; and
along a third direction, the plurality of support structures are arranged side by side and spaced apart, a gap between two adjacent support structures is used for passing through by one chip on film that electrically connects a display panel and a drive board, and a gap exists between the chip on film and the adjacent support structures.

12. The electronic device according to claim 11, wherein each support structure comprises a support rib, and the support rib is disposed between the frame and the first portion and is of an integral structure with one of the frame and the first portion.

13. The electronic device according to any one of claims 1 to 7, wherein the electronic device further comprises a display panel and a non-transparent bonding member, and the support member further comprises a third portion; and
along a second direction, the first portion and the display panel are respectively disposed on two opposite sides of the third portion, a part of the display panel is disposed between the frame and the third portion, and the bonding member is disposed between the third portion and the display panel and is bonded to each of the third portion and the display panel.

14. The electronic device according to claim 13, wherein along the first direction, a lapping width between the display panel and the frame is greater than or equal to 1 mm, and a lapping width between the display panel and the frame is less than or equal to 3 mm.

15. The electronic device according to claim 13, wherein the bonding member comprises a double-sided foam tape.

16. The electronic device according to any one of claims 1 to 7, wherein the frame comprises a second main body portion and a support plate portion;
one end of the support plate portion is detachably connected to the second main body portion, and the other end of the support plate portion is configured to lap with a surface that is of a display panel and that faces away from the optical film along the second direction; and
along the first direction, the first portion is disposed between the second main body portion and the folded edge portion.

17. The electronic device according to claim 16, wherein the support plate portion is any one of the following: a stainless steel plate portion, a plastic plate portion, an aluminum plate portion, a carbon fiber plate portion, a vinyl chloride plate portion, a PCM plate portion, or a polycarbonate plate portion.

18. The electronic device according to claim 16, wherein the second main body portion is bonded to one end of the support plate portion; and
along the second direction, one end that is of the second main body portion and that faces the support plate portion comprises an anti-overflow adhesive stopper and a positioning groove, a top end surface of the anti-overflow adhesive stopper is in contact with a bottom end surface of the support plate portion and defines an accommodation cavity with the bottom end surface of the support plate portion, and a part of the support plate portion is disposed inside the positioning groove.

19. The electronic device according to any one of claims 1 to 7, wherein the electronic device further comprises a plurality of eccentric structures, the plurality of eccentric structures are arranged side by side and spaced apart along a third direction, and along the first direction, the plurality of eccentric structures are disposed between the frame and the first portion, and each eccentric structure is in contact with each of the frame and the first portion.

20. The electronic device according to claim 19, wherein each eccentric structure comprises an eccentric rib, and the eccentric rib is disposed between the frame and the first portion along the first direction and is of an integral structure with one of the frame and the first portion.

21. The electronic device according to claim 19, wherein the frame further comprises a fastening hole, the fastening hole is used for passing through by a fastener that fastens the frame and the folded edge portion, the fastening hole is an eccentric hole, and an axis of the fastening hole is parallel to the first direction.

22. The electronic device according to any one of claims 1 to 7, wherein the frame is a ground facing-side frame

23. The electronic device according to any one of claims 1 to 7, wherein the electronic device is any one of the following: a television, an advertising screen, or a monitor.
